# EUROPÄISCHE PATENTSCHRIFT

(11) **EP 1 218 681 B1**
(45) Veröffentlichungstag und Bekanntmachung des Hinweises auf die Patenterteilung: **15.09.2004**
(21) Anmeldenummer: 00972694.4
(22) Anmeldetag: 06.10.2000
(51) Int. Cl.: F27B 9/14, F26B 15/10, B65G 1/04, B23K 1/008, B23K 37/047

(54) **VERFAHREN UND VORRICHTUNG ZUM TEMPERIEREN VON ELEKTRONISCHEN BAUTEILEN**
METHOD AND DEVICE FOR TEMPERING ELECTRONIC COMPONENTS
PROCEDE ET DISPOSITIF DESTINES A TEMPERER DES COMPOSANTS ELECTRONIQUES

(30) Priorität: 08.10.1999 DE 19948606
(43) Veröffentlichungstag der Anmeldung: 03.07.2002
(73) Patentinhaber: Seho Systemtechnik GmbH, 97892 Kreuzwertheim (DE)
(72) Erfinder: BLOHMANN, Johann, Alfred, 78050 Villingen-Schwenningen (DE); DIEHM, Rolf, 97877 Wertheim (DE); ULLRICH, Rudolf, 97892 Kreuzwertheim (DE)
(74) Vertreter: Bardehle, Heinz, Dipl.-Ing.
(86) Internationale Anmeldenummer: PCT/EP2000/009806
(87) Internationale Veröffentlichungsnummer: WO 2001/027547

(56) Entgegenhaltungen:
- EP-A- 0 429 328
- DE-A- 3 841 167
- DE-A- 19 809 556
- DE-U- 29 619 160
- GB-A- 850 769
- US-A- 5 359 175
- US-A- 5 922 230

## Beschreibung

Die Erfindung bezieht sich ein Verfahren zum Temperieren von auf Trägem befindlichen elektronischen Bauteilen, z.B. Halbleiterschaltkreisen, Leiterplatten und dergleichen vor oder nach dem Verlöten oder zum Aushärten von Vergussmasse, bei dem die Bauteile auf den Trägern durch einen Eingangsschlitz in ein mit Temperierorganen versehenes Temperiergehäuse eingefördert und durch einen dem Eingangsschlitz gegenüberliegenden Ausgangschlitz ausgefördert werden, wobei die Träger in dem Gehäuse von einem verschiebbaren Magazin aufgenommen werden, das mit benachbart angeordneten Haltern zur Aufnahme der einzelnen Träger versehen ist.

Eine Vorrichtung zum Temperieren von Werkstücken ist aus der DE-OS 4020920 bekannt. Bei dieser Vorrichtung handelt es sich um einen Durchlaufofen zum Vorwärmen von einer Weiterverarbeitung zuzuführenden Werkstücken. Dieser Durchlaufofen enthält zwei Transportsysteme, die jeweils nach Art zweier nebeneinander angeordneter Paternoster gestaltet sind, die über eine obere und eine untere Umlenkrolle geführte Umlaufbänder enthalten. Die Drehrichtung der Umlenkrollen ist dabei so gewählt, dass die einander zugewandten Trums der Umlaufbänder jeweils in gleicher Richtung laufen, so dass an den Umlaufbändem angebrachte Aufnàhmeteile im Bereich zwischen zwei Umlaufbändern entweder eine Aufwärtsbewegung oder Abwärtsbewegung ausführen. Aufgrund der Anordnung zweier solcher Transportsysteme hintereinander, d.h. mit koaxialliegenden Achsen der oberen Umlenkrollen und unteren Umlenkrollen, und einer Antriebsrichtung der Umlenkrollen im einen Transportsystem entgegengesetzt zu der Antriebsrichtung in dem anderen Transportsystem, ergibt sich für in jeweils ein Transportsystem eingeschobene Formbleche zum Tragen der zu behandelnden Werkstücke ein Aufwärtstransport dieser Formbleche, deren Übergabe von dem aufwärtstransportierenden Transportsystem zu dem abwärtstransportierenden Transportsystem und ein Abwärtstransport in dem letzteren Transportsystem. Dabei werden das aufwärtstransportierende Transportsystem durch einen in seinem unteren Bereich liegenden Eingangsschlitz in dem Durchlaufofen beschickt und im unteren Ende des abwärtstransportierenden Transportsystems die Formbleche über einen Ausgabeschlitz abgeführt, wobei Eingabe- und Ausgabeschlitz einander gegenüber liegen. Damit der Transport über die beiden Transportsysteme und von einem Transportsystem zum anderen störungsfrei ablaufen kann, wird die Bewegung der Transportsysteme in entsprechender Weise getaktet.

Es ist weiterhin aus der US-PS 51.58224 ein Heizgehäuse für die Vorheizung von zu lötenden Schaltungsplatten bekannt, das ein Transportsystem nach Art eines Transportsystems der vorstehend behandelten Druckschrift benutzt. Die Schaltungsplatten werden durch einen im unteren Bereich des Temperiergehäuses befindlichen Schlitz in den Innenraum des Gehäuses eingeschoben und dabei von den beiden gegenüberliegenden Transportbändern seines einzigen Transportsystems erfasst, das dann die Schaltungsplatten aufwärts transportiert, bis diese in die Höhe eines im oberen Bereich des Gehäuses liegenden Ausgabeschlitzes gelangen, aus dem dann die im Innenraum des Gehäuses erwärmten Schaltungsplatten ausgeschoben werden.

Der Erfindung liegt die Aufgabe zugrunde, den Ablauf des vorstehend erwähnten Temperierverfahrens zu verbessern. Erfindungsgemäß geschieht dies dadurch, dass das Magazin schrittweise in einer Richtung aus einer Ausgangslage und nach Beschicken des ersten Halters in dieser Ausgangslage in aufeinanderfolgende Aufnahmepositionen verschoben wird, in denen nacheinander die einzelnen Halter des Magazins lückenlos beschickt werden, woraufhin nach Beschickung sämtlicher Halter das so voll gefüllte Magazin aus der dabei erreichten Endlage in entgegengesetzter Richtung in schnellem Rücklauf in seine Ausgangslage zurück verschoben wird; in der das Einfördern eines Trägers durch den Eingangsschlitz und das hierdurch bewirkte Ausfördern des auf dem betreffenden Halter liegenden Trägers durch den Ausgangsschlitz bewirkt und ein temperierter Träger durch einen nicht temperierten Träger ersetzt wird, bis alle Halter des Magazins bei gleicher Verweilzeit der Träger im Magazin in seiner erreichten Endlage wieder beschickt sind, woraufhin nach Rücklauf des Magazins in die Ausgangslage erneut die schrittweise Beschickung des Magazins erfolgt.

Beim Ablauf dieses Verfahrens ergibt sich innerhalb des Temperiergehäuses eine Hin- und Herbewegung, bzw. Auf- und Abbewegung ohne irgendwelche Umlenkungen und ohne dass zwischen den beiden Bewegungsrichtungen eine Übergabefunktion zu erfolgen hat, wobei für die Hin- und Herbewegung ein einziger einfacher Verschiebemechanismus erforderlich ist.

Dabei wird auf jeden zu temperierenden Träger einheitlich für einen bestimmten Zeitraum eingewirkt, nämlich deren Verweilzeit im Temperiergehäuse, definiert durch den Zeitraum zwischen zwei Rückläufen.

Vorteilhaft erfolgt die Verschiebung des Magazins in dem Temperiergehäuse in Vertikalrichtung. Bei dieser Anordnung ergibt sich eine relativ geringe Stellfläche für das Temperiergehäuse, da dieses lediglich einen vertikalen Raum benötigt, in dem sich eine einzige Auf- und Abbewegung abspielt. Diese Auf- und Abbewegung kann man von der Ausgangslage in die Endlage entweder von unten nach oben oder von oben nach unten gestalten. Bei einer Verschiebung des Magazins von der Ausgangslage in die Endlage von unten nach oben ergibt sich eine Erleichterung für die schnelle Rückbewegung des gefüllten Magazins von der Endlage zurück in die Ausgangslage, nämlich von oben nach unten, da hierbei die Schwerkraft diese schnelle Bewegung unterstützt.

Es sei aber daraufhingewiesen, dass die Verschiebung des Magazins auch in Horizontalrichtung erfolgen kann, wenn dies die Beschickung des Temperaturgehäuses und die Abnahme der temperierten Träger notwendig erscheinen lässt.

Bei der Vorrichtung zur Durchführung des oben geschilderten Verfahrens handelt es sich um ein mit Temperierorganen versehenes Temperiergehäuse mit einem Magazin, das mit Haltern zur Aufnahme der Träger versehen ist und einen Verschiebemechanismus zur Verschiebung des Magazins enthält. Diese Vorrichtung wird erfindungsgemäß derart gestaltet, dass das Temperiergehäuse etwa die doppelte Höhe des Magazins aufweist und in seinem mittleren Bereich den Eingangsschlitz und gegenüberliegend den Ausgangsschlitz aufweist, dass das Magazin mit einem Verschiebemechanismus zu seiner schrittweisen Verschiebung sowohl zum schrittweisen lückenlosen Beschicken der einzelnen Halter als auch zum durch das Beschicken bewirkten schrittweisen Ausfördern der jeweils in fluchtender Lage zu dem Eingangs- und dem Ausgangsschlitz (Aufnahmeposition) liegenden Halter versehen ist, und dass die Temperierorgane den Innenraum des Gehäuses auf eine derart einstellbare Temperatur bringen, dass während der Verweilzeit die Bauteile eine gewünschte Temperatur annehmen.

Bei dieser Gestaltung ergibt sich eine Öffnung des Temperaturgehäuses für den Eingangsschlitz und den Ausgangsschlitz etwa in der Mitte des Gehäuses, was für den thermischen Haushalt des Temperaturgehäuses günstig ist. Darüber hinaus ist für die Führung des Magazins in dem Temperiergehäuse lediglich ein einziger gradlinig wirkender Verschiebemechanismus erforderlich, der die Bewegung des Magazins sowohl in Aufwärts- als auch in Abwärtsrichtung bewirkt. Die in dem Gehäuse untergebrachten Temperierorgane sorgen dafür, dass mit Rücksicht auf die durch den Verschiebemechanismus definierte Verweilzeit der Bauteile die Einstellung der von den Bauteilen anzunehmenden Temperatur durch eine einstellbare Temperatur der Temperierorgane problemlos vorgenommen werden kann.

Die erfindungsgemäße Vorrichtung läßt sich vorteilhaft für die Aufheizung von Leiterplatten vor der Aufschmelzzone einer Lötanlage verwenden, wobei die Temperierorgane durch Heizer gebildet sind. Es ist aber auch möglich, die Vorrichtung im Anschluß an die Aufschmelzzone einer Lötanlage anzuordnen, wozu dann die Temperierorgane durch Kühler zu bilden sind.

Da es sich bei der Vorrichtung für sich um ein abgeschlossenes Gebilde handelt, ist es möglich, mehrere derartige Vorrichtungen benachbart zueinander anzuordnen und deren Eingangs- und Ausgangsschlitze miteinander zu verbinden. Hierdurch läßt sich eine individuelle und stufenweise Temperierung von Bauteilen, insbesondere die Aushärtung von Vergußmassen im Zusammenhang mit Halbleiterschaltkreisen, bewerkstelligen.

In den Figuren sind Ausführungsbeispiele der Erfindung dargestellt. Es zeigen:
- Figur 1: eine Seitenansicht eines Temperiergehäuses mit Magazin, das einer Aufschmelzzone einer Lötanlage vorgeordnet ist, und zwar in der Ausgangslage des Magazins,
- Figur 2: die gleiche Anordnung mit angehobenem Magazin, das teilweise mit Trägem beschickt ist,
- Figur 3: die gleiche Anordnung in der Endlage des Magazins, in dem dieses vollständig gefüllt ist und damit unmittelbar vor der schnellen Rückverschiebung in die Ausgangslage steht,
- Figur 4: eine Lötanlage mit einem davor und dahinter angeordneten Temperiergehäuse,
- Figur 5: das Temperiergehäuse in der Lage gemäß Figur 3, jedoch in einer um 90° gedrehten Seitenansicht,
- Figur 6: eine Anordnung einer Mehrzahl von Temperiergehäusen unmittelbar nebeneinander mit in Verbindung stehenden Eingangs- und Ausgangsschlitzen.

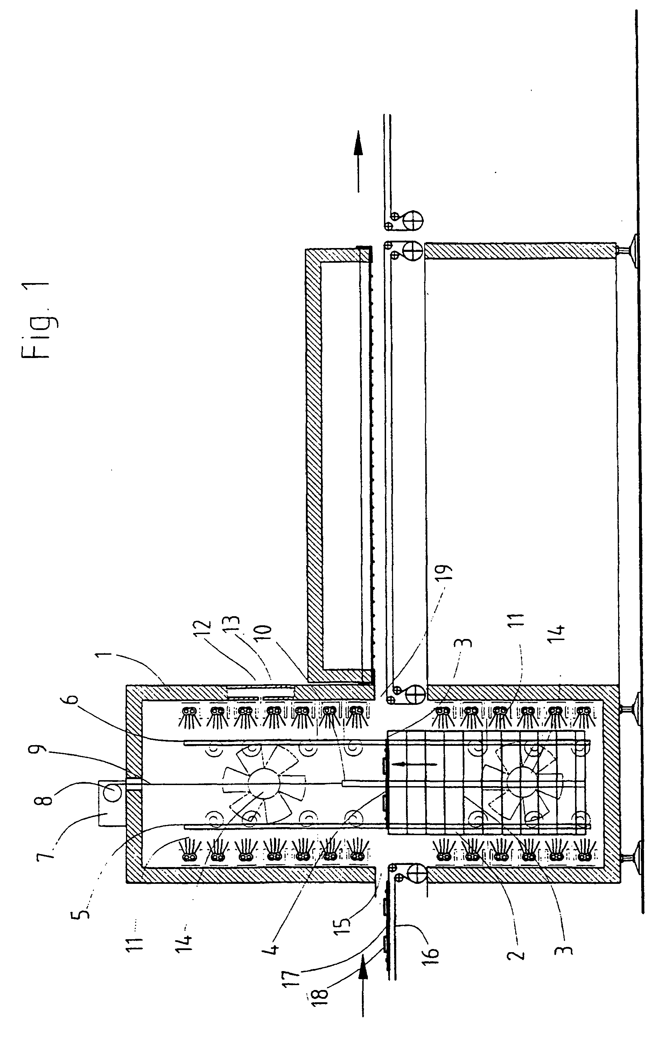

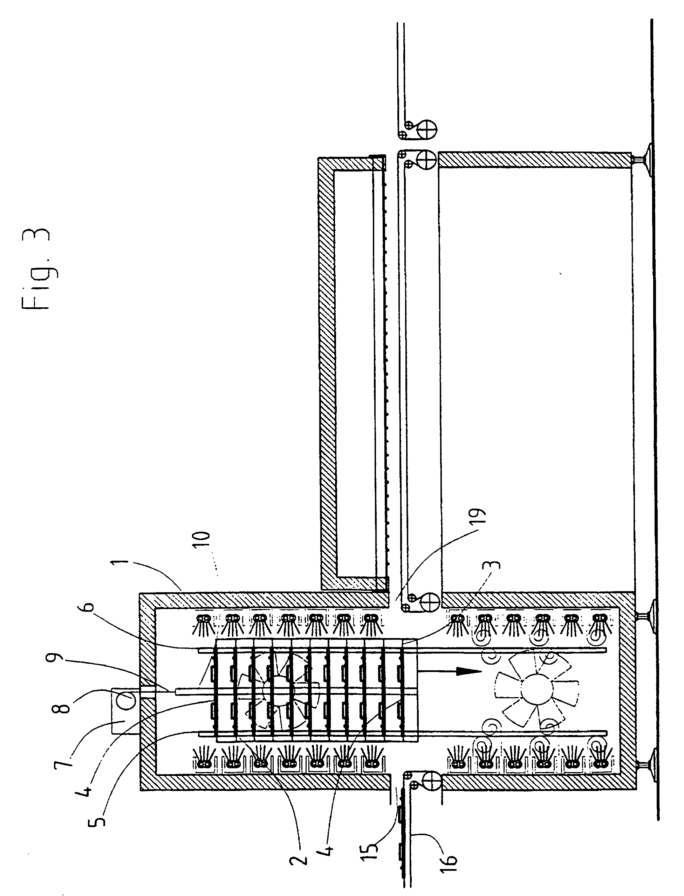

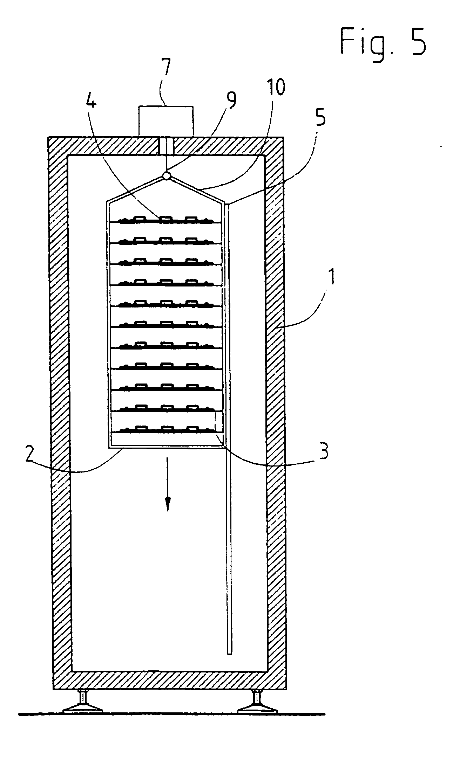

In der Figur 1 ist das Temperiergehäuse 1 mit einer relativ dicken temperaturisolierenden Wandung dargestellt, in dem das Magazin 2 längsverschiebbar untergebracht ist. Das Magazin 2 ist mit einzelnen, übereinander in gleichem Abstand zueinander angeordneten Haltern 3 versehen, die für die Aufnahme an einzelnen Trägem 4 dienen. Gemäß Figur 1 liegt auf dem obersten Halter 3der Träger 4 auf. Das Magazin 2 wird von den Führungsschienen 5 und 6 geführt, die an der Wand des Temperiergehäuses 1 befestigt sind. Um das Magazin 2 in dem Temperiergehäuse 1 entlang den Führungsschienen 5 und 6 vertikal zu bewegen, ist der hier als Hubmechanismus 7 ausgebildete Verschiebemechanismus vorgesehen, der die Aufwickelrolle 8aufweist, auf der das Zugseil 9 aufwickelbar ist. Das Zugseil 9 ist an dem Bügel 10 eingehängt, der hinsichtlich seiner Gestaltung im Zusammenhang mit der Figur 5 näher erläutert wird. Durch Aufrollen des Zugseiles 9 wird das Magazin 2 hochgeschoben, bis es in seine aus Figur 3 ersichtliche Endlage gelangt, worauf weiter unten näher eingegangen wird.

In dem Temperiergehäuse lsind zur Beheizung seines Innenraumes als Heizstrahler 11 ausgebildete Heizer und Lüftungsschlitze 12 vorgesehen. Den Lüftungsschlitzen 12 wird über in der Wandung des Temperiergehäuses 1 untergebrachte Kanäle 13 Heißluft zugeführt, die zusätzlich zu den Heizstrahlern 11 für eine Erwärmung des Innenraums des Temperiergehäuses 1 sorgen. Wie ersichtlich, sind über die Innenwand des Temperiergehäuses 1 eine größere Anzahl von Heizstrahlern 11 und Lüftungsschlitzen 12 untergebracht, so daß sich für den Innenraum des Temperiergehäuses 1 eine sehr gleichmäßige Durchwärmung ergibt. Um die im Innenraum des Temperiergehäuses 1 befindliche Luft in ihrem erwärmten Zustand in dem gesamten Innenraum gut zu verteilen, sind zusätzlich die beiden Umluftgebläse 14 vorgesehen.

Das Magazin 2 ist für eine Beschickung mit den Trägem 4 vorgesehen, von denen einer, wie oben bereits dargelegt, auf dem obersten Halter 3 aufliegt. Die einzelnen Träger werden in das Temperiergehäuse 1 durch den Eingangsschlitz 15 eingefördert, und zwar mit Hilfe des Transportbandes 16, auf dem gemäß Darstellung in Figur 1 bereits der Träger 17 mit darauf angebrachten Halbleiterschaltkreisen 18 aufliegt. Bei Vorwärtsbewegung des Transportbandes 16 wird der Träger 17 durch den Eingangsschlitz 15 zu dem Magazin 2 hin gefördert, das damit mit einem Träger beschickt wird, wie dies bei dem Träger 4 der Fall ist.

Gemäß dem erfindungsgemäßen Verfahren wird nun das Magazin 2 schrittweise mittels des Hubmechanismus 7 angehoben, und zwar so, daß jeweils ein Halter 3 in eine fluchtende Lage zu dem Eingangsschlitz 15 gelangt, die die Aufnahmeposition bildet. Auf diese Weise läßt sich vom Transportband 16 her das Magazin 2 schrittweise in den gefüllten Zustand bringen, bei dem sämtliche Halter 3 des Magazins 2 mit einem Träger 4 beschickt sind.

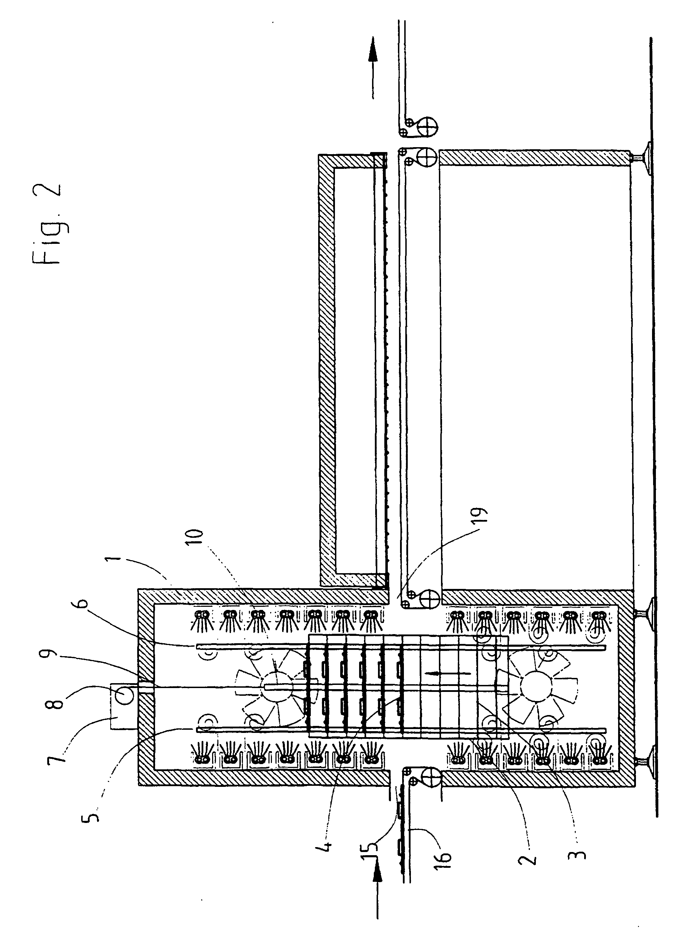

In der Figur 2 ist die Anordnung gemäß Figur 1 in einer Lage dargestellt, in der das Magazin 2 teilweise mit Trägem 4 beschickt ist. Diese durch das Förderband 16 bewirkte Beschickung des Magazins 2 geht dann weiterhin schrittweise vor sich. bis das Magazin 2 vollständig gefüllt ist.

Dieser Zustand, in dem das Magazin 2 seine Endlage einnimmt, ist in der Figur 3 dargestellt. Mit Erreichen dieser Endlage war dem Magazin 2 für seinen untersten Halter 3 ein Träger 4 zugeführt worden. Das somit vollständig gefüllte Magazin 2 wird dann anschließend in schnellem Rücklauf wieder in die in der Figur 1 dargestellte Ausgangslage zurück verschoben, wofür nur ein kurzer Zeitraum, z.B. einige Sekunden, erforderlich sind.

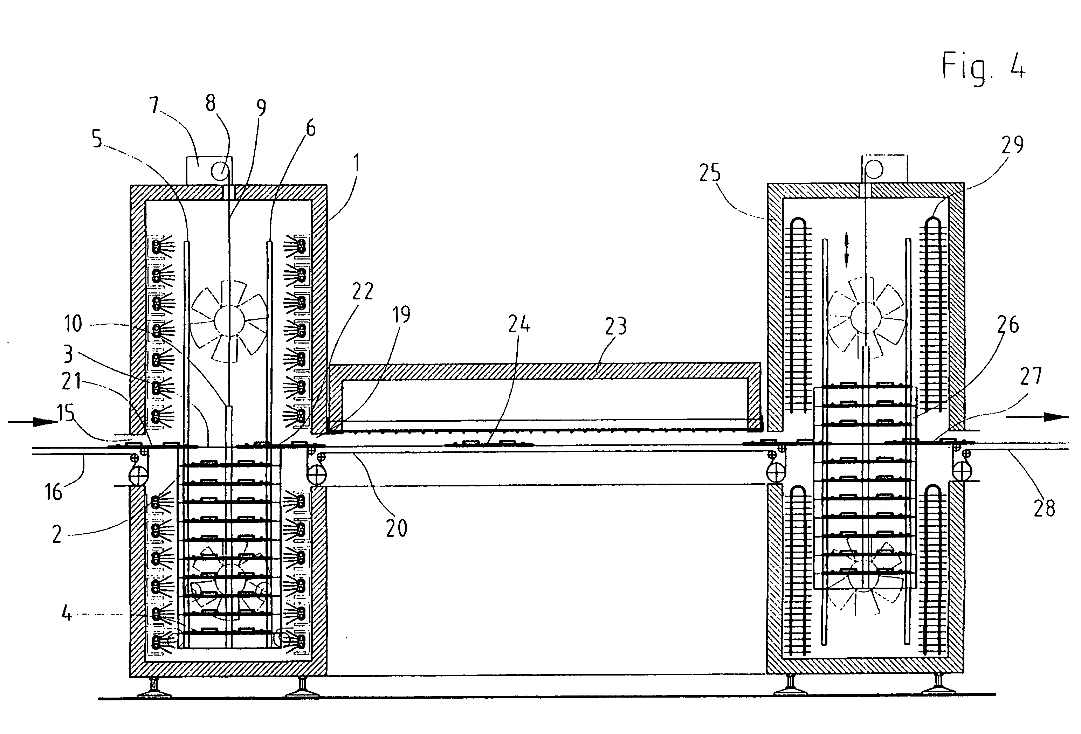

Nach dem Wiedererreichen der Ausgangslage des Magazins 2, und zwar nunmehr mit gefülltem Magazin, nimmt dieses die in der Figur 4 dargestellte Position ein, die nunmehr dazu dient, die im Magazin 2 temperierten Träger 4 aus dem Magazin 2 und dem Temperiergehäuse auszufördern. Dieser Vorgang ist in der Figur 4 dargestellt. Wenn einem mit dem Eingangsschlitz 15 fluchtenden Halter 3 ein neuer Träger 21 zugeführt wird, so wird hierdurch das Ausfördern des auf dem betreffenden Halter liegenden Trägers 22 bewirkt, der dabei durch den dem Eingangsschlitz 15 gegenüberliegenden Ausgangsschlitz 19 ausgefördert wird. Dieser Träger 22 gelangt dabei über das dem Temperiergehäuse 1 folgende Transportband 20 in weitere Bearbeitungsstationen einer Lötanlage 23, auf die weiter unten näher eingegangen wird. Dieser Vorgang des Ein- und Ausförderns von Trägem in das Magazin 2 geht nun prinzipiell in der gleichen Weise vor sich. wie im Zusammenhang mit den Figuren 1 und 2 das Befüllen des Magazins 2 geschildert worden ist, wobei allerdings nach erfolgter Befüllung des Magazins 2 ( siehe Figur 4) nunmehr die im Magazin 2 befindlichen Träger einzeln nacheinander durch neu zugeförderte Träger weggefördert werden, wie dies beim Träger 22 angedeutet ist. Dieser Vorgang geht nun schrittweise wie beim Befüllen des Magazins 2 gemäß Figuren 1 und 2 vor sich, wobei jeweils ein neuer Träger dafür sorgt, daß ein bereits temperierter Träger ausgefördert wird, d.h. es wird bei jedem dieser aufeinanderfolgenden Schritte ein temperierter Träger 22 durch einen nicht temperierten Träger 21 ersetzt. Dieser Vorgang läuft ab, bis das Magazin 2 seine Endlage gemäß Figur 3 erreicht hat, in der das Magazin 2 vollständig mit nicht temperierten Trägem befüllt ist und sämtliche im Magazin vorher befindlichen temperierten Träger ausgefördert worden sind. Dabei ergibt sich für jeden zu temperierenden Träger die gleiche Verweilzeit im Temperiergehäuse 1, nämlich einen Zeitraum, der zwei Rückläufen des Magazins 2, also den Übergang der Position in Figur 3 zur Position gemäß Figur 1, entspricht, da für jeden Träger, abgesehen von dem schnellen Rücklauf des Magazins 2, jeweils ein Zeitraum für das Temperieren zur Verfügung steht, der sich aus der Anzahl der Schrittzeiten zusammensetzt, die vom Einfördern eines Trägers bis zu seinem Ausfördern vergeht, wozu jeweils soviel Schritte erforderlich sind, wie das Magazin Halter aufweist.

In der Figur 4 ist weiterhin dargestellt, wie die aus dem Temperiergehäuse 1 ausgeförderten Träger 22 in den Bereich einer Lötanlage 23 gelangen, bei der es sich um eine bekannte Baugruppe handelt, in der das Aufschmelzen des Lots durch entsprechende kurze Temperaturerhöhung erfolgt. Die Träger 22 und 24 werden mittels des Transportbandes 20 nicht nur durch den Ausgangsschlitz 19 übernommen, sondern auch durch die Lötanlage 23 hindurchtransportiert und gelangen schließlich am Ende der Lötanlage 23 in ein weiteres Temperiergehäuse 25, in der eine erforderliche Kühlung der Träger 24 mit auf diesen befindlichen Bauteilen erfolgt. In dem Temperiergehäuse 25 ist der gleiche Mechanismus für das Hin- und Herbewegen eines Magazins 26 untergebracht, das in der gleichen Weise, wie dies im Zusammenhang mit den Temperiergehäuse 1 beschrieben ist, mit einzelnen Trägem beschickt wird, wobei dann die bereits temperierten Träger 27 aus dem Temperiergehäuse 25 ausgefördert und von einem weiteren Transportband 28 zur weiteren Verarbeitung übernommen werden. Dabei spielt sich im Inneren des Temperiergehäuses 25 der gleiche Vorgang des Anhebens und Zurückschiebens des Magazins 26 ab, so daß bezüglich dieser Vorgänge auf die Erläuterung zu den Figuren 1 bis 3 verwiesen werden kann. In Abweichung von der Gestaltung des Temperiergehäuses 1 ist das Temperiergehäuse 25 mit Kühlem 29 versehen, die dafür sorgen, daß die Träger mit den von ihnen getragenen Bauteilen auf die für die weitere Bearbeitung erforderliche Temperatur abgekühlt werden.

In Figur 5 ist das Temperiergehäuse 1 mit gefülltem Magazin entsprechend der Darstellung in Figur 3 gezeigt, und zwar demgegenüber um 90° gedreht. Dabei sind die in der Figur 3 eingezeichneten Temperierorgane aus Gründen der Vereinfachung und Übersichtlichkeit der Darstellung weggelassen. Gemäß Figur 5 hängt das Magazin 2 über die Bügel 10 an dem Zugseil 9. Die Bügel 10 gehen in das Magazin 2 über und bilden damit die Verbindung zwischen Magazin 2 und dem Zugseil 9. In Figur 5 ist noch die Führungsschiene 5 dargestellt, die Führungsschiene 6 gemäß Figur 3 ist in der Ansicht gemäß Figur 5 durch die Führungsschiene 5 verdeckt. Die beiden Führungsschienen 5 und 6 genügen für die Führung des Magazins 2 bei seiner Auf- und Abbewegung.

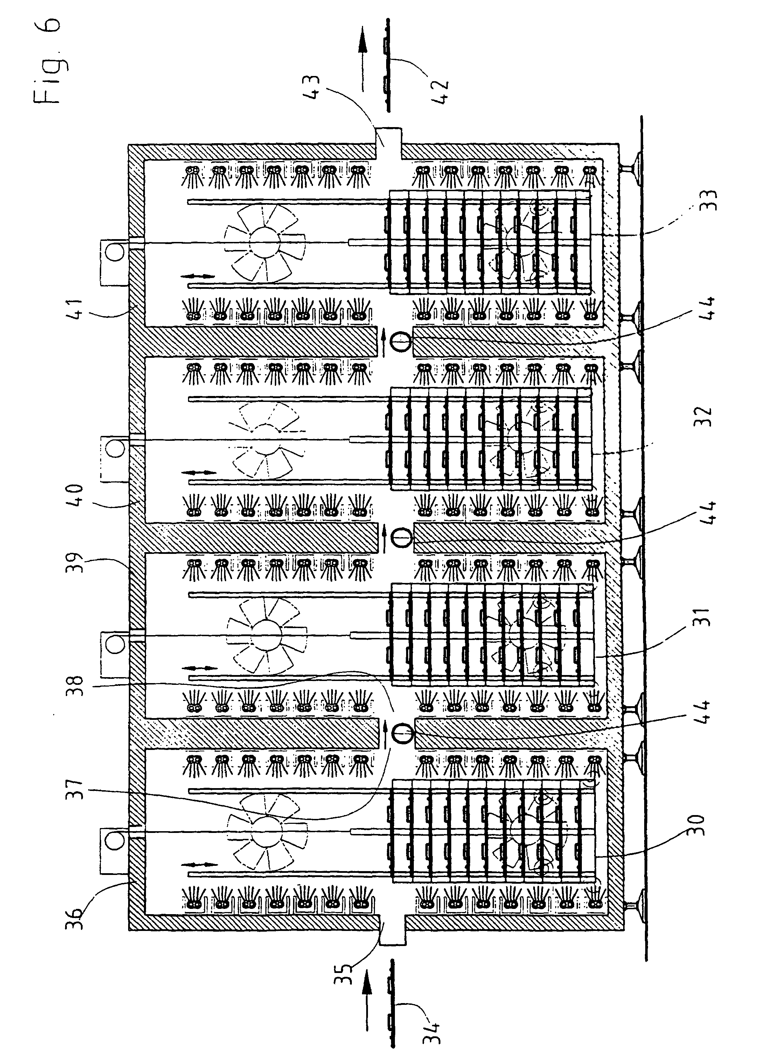

In der Figur 6 sind mehrere Temperiergehäuse mit in ihnen im Sinne der vorstehenden Darlegungen verschiebbaren Magazinen 30, 31, 32 und 33 dargestellt, bei denen die jeweiligen Eingangs- und Ausgangsschlitze in Verbindung stehen. Hierdurch können Träger durch den Eingangsschlitz 35 des ersten Temperiergehäuses 36 in dieses eingefördert und nach Temperierung durch dessen Ausgangsschlitz 37, der gleichzeitig den Eingangsschlitz 38 des Temperiergehäuses 39 bildet, weitergefördert werden. Auf diese Weise lassen sich durch entsprechend gestaltete weitere Temperiergehäuse 40 und 41 die Träger nach jeweiliger Temperierung in den vorherigen Temperiergehäusen hindurchfördern, bis schließlich die Träger 42 durch den Ausgangsschlitz 43 des letzten Temperiergehäuses 41 heraustransportiert werden. Die Übergabe von einem Temperaturgehäuse zum anderen erfolgt zweckmäßig durch Übergaberollen 44, auf denen die von Temperiergehäuse zu Temperiergehäuse geförderten Träger aufliegen und aufgrund der Drehung der Übergaberollen 44 problemlos in das nächste Temperiergehäuse eingefördert werden können. Wie die Figur 6 zeigt, lassen sich dabei die einzelnen Temperiergehäuse im Bereich ihres Aneinanderstoßens wandungsmäßig vereinheitlichen. Es ist dies jedoch keine Erfordernis, es können natürlich einzelne jeweils mit vollständiger Wandung versehene Temperiergehäuse aneinander gerückt werden.

Die einzelnen Temperiergehäuse 36 bis 41 lassen jeweils eine eigene individuelle Behandlung der hindurchgeführten Träger mit den von ihnen getragenen Bauelementen zu, beispielsweise beginnend mit einer relativ schwachen Beheizung, die dann über die folgenden Temperiergehäuse 39 und 40 zunimmt und schließlich über das Temperiergehäuse 41 wieder abnimmt. Es ist aber natürlich auch jede andere stufenweise Temperierung möglich, je nachdem wie die Beheizung in den einzelnen Temperiergehäusen gewählt wird. Insbesondere ist eine derartige Behandlung bei der Aushärtung von Vergußmassen von Halbleiterschaltkreisen günstig, die dafür einen thermischen Langzeitprozess von bis zu mehreren Stunden durchlaufen müssen.

Die Steuerung der einzelnen Temperiergehäuse, die in den vorstehend behandelten Figuren dargestellt sind, kann man in bekannter Weise mittels eines elektronischen Steuersystems herbeiführen, das jedoch nicht Gegenstand der vorliegenden Erfindung ist. Derartige elektronische Steuersysteme für beliebig komplexe Vorgänge sind bekannt und im Rahmen der vorliegenden Erfindung als Stand der Technik ohne weiteres verwendbar.

### BEZUGSZEICHENLISTE

- 1): Temperiergehäuse
- 2): Magazin
- 3): Halter
- 4): Träger
- 5): Führungsschienen
- 6): Führungsschienen
- 7): Hubmechanismus
- 8): Aufwickelrolle
- 9): Zugseil
- 10): Bügel
- 11): Heizstrahler
- 12): Lüftungsschlitze
- 13): Kanäle
- 14): Umluftgebläse
- 15): Eingangsschlitz
- 16): Transportband
- 17): Träger
- 18): Halbleiterschaltkreis
- 19): Ausgangsschlitz
- 20): Transportband
- 21): Träger
- 22): Träger
- 23): Lötanlage
- 24): Träger
- 25): Temperiergehäuse
- 26): Magazin
- 27): Träger
- 28): Transportband
- 29): Kühler
- 30): Magazin
- 31): Magazin
- 32): Magazin
- 33): Magazin
- 34): Träger
- 35): Eingangsschlitz
- 36): Temperiergehäuse
- 37): Ausgangsschlitz
- 38): Eingangsschlitz
- 39): Temperiergehäuse
- 40): Temperiergehäuse
- 41): Temperiergehäuse
- 42): Träger
- 43): Ausgangsschlitz
- 44): Übergaberollen

## Patentansprüche

1. Verfahren zum Temperieren von auf Trägem befindlichen elektronischen Bauteilen, z.B. Halbleiterschaltkreisen (18), Leiterplatten und dergleichen vor oder nach dem Verlöten oder zum Aushärten von Vergussmasse, bei dem die Bauteile auf den Trägem (4, 17, 21, 22, 24, 27, 34, 42) durch einen Eingangsschlitz in ein mit Temperierorganen (11, 12) versehenes Temperiergehäuse (1) eingefördert und durch einen dem Eingangsschlitz (15) gegenüberliegenden Ausgangschlitz (19) ausgefördert werden, wobei die Träger (4, 17, 21, 22, 24, 27, 34, 42) in dem Gehäuse (1) von einem verschiebbaren Magazin (2) aufgenommen werden, das mit benachbart angeordneten Haltern (3) zur Aufnahme der einzelnen Träger (4, 17, 21, 22, 24, 27, 34, 42) versehen ist, **dadurch gekennzeichnet, dass** das Magazin (2) schrittweise in einer Richtung aus einer Ausgangslage und nach Beschicken des ersten Halters (3) in dieser Ausgangslage in aufeinanderfolgende Aufnahmepositionen verschoben wird, in denen nacheinander die einzelnen Halter des Magazins (2) lückenlos beschickt werden, woraufhin nach Beschickung sämtlicher Halter (3) das so voll gefüllte Magazin aus der dabei erreichten Endlage in entgegengesetzter Richtung in schnellem Rücklauf in seine Ausgangslage zurück verschoben wird, in der das Einfördern eines Trägers (4, 17, 21, 22, 24, 27, 34, 42) durch den Eingangsschlitz (15) und das hierdurch bewirkte Ausfördern des auf dem betreffenden Halter liegenden Trägers (22) durch den Ausgangsschlitz (19) bewirkt und ein temperierter Träger (22) durch einen nicht temperierten Träger (21) ersetzt wird, bis alle Halter (3) des Magazins (2) bei gleicher Verweilzeit der Träger im Magazin (2) in seiner erreichten Endlage wieder beschickt sind, woraufhin nach Rücklauf des Magazins (2) in die Ausgangslage erneut die schrittweise Beschickung des Magazins (2) erfolgt.

2. Verfahren nach Anspruch 1, **dadurch gekennzeichnet, dass** die Verschiebung des Magazins (2) von der Ausgangslage in die Endlage in Vertikalrichtung von unten nach oben erfolgt.

3. Verfahren nach Anspruch 1, **dadurch gekennzeichnet, dass** die Verschiebung des Magazins (2) von der Ausgangslage in die Endlage in Vertikalrichtung von oben nach unten erfolgt.

4. Vorrichtung zur Durchführung des Verfahrens nach einem der Ansprüche 1 bis 3 an auf Trägern befindlichen elektronischen Bauteilen, wobei die Vorrichtung ein mit Temperierorganen (11, 12) versehenes Temperiergehäuse (1) mit einem Magazin (2) aufweist, das mit Haltern (3) zur Aufnahme der Träger (4, 17, 21, 22, 24, 27, 34, 42) versehen ist und einen Verschiebemechanismus (7, 8, 9) zur Verschiebung des Magazins (2) enthält, **dadurch gekennzeichnet, dass** das Temperiergehäuse (1) etwa die doppelte Höhe des Magazins (2) aufweist und in seinem mittleren Bereich den Eingangsschlitz (15) und gegenüberliegend den Ausgangsschlitz (19) aufweist, dass das Magazin (2) mit einem Verschiebemechanismus (7, 8, 9) zu seiner schrittweisen Verschiebung sowohl zum schrittweisen lükkenlosen Beschicken der einzelnen Halter als auch zum durch das Beschicken bewirkten schrittweisen Ausfördern der jeweils in fluchtender Lage zu dem Eingangs- und dem Ausgangsschlitz (15, 19) (Aufnahmeposition) liegenden Halter versehen ist, und dass die Temperierorgane (11, 12) den Innenraum des Gehäuses (1) auf eine derart einstellbare Temperatur bringen, dass während der Verweilzeit die Bauteile (18) eine gewünschte Temperatur annehmen.

5. Vorrichtung nach Anspruch 4, **dadurch gekennzeichnet, daß** sie der Aufschmelzzoner einer Lötanlage ( 23 ) vorgeordnet ist und die Temperierorgane durch Heizer ( 11, 12 ) gebildet sind.

6. Vorrichtung nach Anspruch 4, **dadurch gekennzeichnet, daß** sie der Aufschmelzzone einer Lötanlage ( 23 ) nachgeordnet ist und die Temperierorgane durch Kühler ( 29 ) gebildet sind.

7. Vorrichtung nach Anspruch 4, **gekennzeichnet durch** eine Mehrzahl von benachbart angeordneten Temperiergehäusen ( 36, 39, 40, 41 ), deren Eingangs- und Ausgangsschlitze ( 37, 38 ) untereinander in Verbindung stehen.

## Claims

1. Method of controlling the temperature of electronic components situated on carriers, e.g. semi-conductor circuits (18), printed circuit boards and the like, before or after soldering or for the setting of potting compounds, in which the components are conveyed on the carriers (4, 17, 21, 22, 24, 27, 34, 42) through an inlet slot into a temperature control housing (1) provided with temperature control elements (11, 12) and out through an outlet slot (19) situated opposite the inlet slot (15), the carriers (4, 17, 21, 22, 24, 27, 34, 42) being received in the housing (1) by a displaceable magazine (2) provided with holders (3) arranged adjacent to one another for receiving the individual carriers (4, 17, 21, 22, 24, 27, 34, 42), **characterised in that**, once the first holder (3) has been loaded in a starting position, the magazine (2) is displaced gradually in one direction from this starting position into successive receiving positions in which the individual holders of the magazine (2) are fully loaded one after the other, after which, once all of the holders (3) have been loaded, the magazine fully loaded in this manner is returned rapidly in the opposite direction from the end position thus reached to its starting position in which a carrier (4, 17, 21, 22, 24, 27, 34, 42) is conveyed in through the inlet slot (15) and the carrier (22) situated on the relevant holder is consequently conveyed out through the outlet slot (19), and a temperature-controlled carrier (22) is replaced by a non-temperature-controlled carrier (21) until all of the holders (3) of the magazine (2) have been loaded once again in the end position reached, given the same dwell time for the carriers in the magazine (2), after which, once the magazine (2) has been returned to the starting position, the magazine (2) is once again gradually loaded.

2. Method according to claim 1, **characterised in that** the magazine (2) is displaced upwardly in a vertical direction from the starting position to the end position.

3. Method according to claim 1, **characterised in that** the magazine (2) is displaced downwardly in a vertical direction from the starting position to the end position.

4. Device for carrying out the method according to one of claims 1 to 3 on electronic components situated on carriers, in which the device comprises a temperature control housing (1) provided with temperature control elements (11, 12) and having a magazine (2) provided with holders (3) for receiving the carriers (4, 17, 21, 22, 24, 27, 34, 42) and containing a displacement mechanism (7, 8, 9) for displacing the magazine (2), **characterised in that** the temperature control housing (1) is approximately twice the height of the magazine (2) and is provided in its central region with the inlet slot (15) and opposite it the outlet slot (19), that the magazine (2) is provided with a displacement mechanism (7, 8, 9) for the gradual displacement thereof both for the gradual complete loading of the individual holders and for the gradual outward conveying of the respective holders situated in an aligned position with the inlet and outlet slots (15, 19) (receiving position) as a result of the loading, and that the temperature control elements (11, 12) bring the interior of the housing (1) to a temperature which can be set in such a manner that the components (18) assume a desired temperature during the dwell time.

5. Device according to claim 4, **characterised in that** it is arranged upstream of the fusing zone of a soldering installation (23) and the temperature control elements are formed by heaters (11, 12).

6. Device according to claim 4, **characterised in that** it is arranged downstream of the fusing zone of a soldering installation (23) and the temperature control elements are formed by coolers (29).

7. Device according to claim 4, **characterised by** a plurality of temperature control housings (36, 39, 40, 41) arranged adjacent to one another, the inlet and outlet slots (37, 38) of which are connected together.

## Revendications

1. Procédé pour mettre en température des composants électroniques situés sur des supports, par exemple des circuits à semiconducteurs (18), des plaquettes à circuits imprimés et analogues avant ou après le brasage ou pour le durcissement d'une masse de scellement, selon lequel on introduit les composants situés sur les supports (4, 17, 21, 22, 24, 27, 34, 42) à travers une fente d'entrée dans un boîtier de mise en température (1) équipé d'organes de mise en température (11, 12) et en les fait sortir par une fente de sortie (19) située à l'opposé de la fente d'entrée (15), les supports (4, 17, 21, 22, 24, 27, 34, 42) étant reçus dans le boîtier (1), par un magasin déplaçable (2), qui est équipé d'organes de retenue (3) voisins et servant à recevoir les différents supports (4, 17, 21, 22, 24, 27, 34, 42), **caractérisé en ce qu'**on déplace le magasin (2) pas-à-pas dans une direction depuis une position de départ et après chargement du premier organe de retenue (3) dans cette position de départ, dans des positions successives de réception, dans lesquelles les différents organes de retenue du magasin (2) sont chargés, successivement sans interruption, à la suite de quoi, après le chargement de tous les organes de retenue (3), le magasin ainsi rempli complètement est ramené dans la direction opposée selon un mouvement de retour rapide, dans sa position de départ, dans laquelle l'introduction d'un support (4, 17, 21, 22, 24, 27, 34, 42) par la fente d'entrée (15) et l'évacuation, provoquée de ce fait, du support (22) situé sur l'organe de retenue considéré, par la fente de sortie (19) sont réalisées et un support (22) mise en température est remplacé par un support (21) non mis en température, jusqu'à ce que tous les organes de retenue (3) du magasin (2) soient à nouveau chargés pour un même temps de séjour des supports dans le magasin (2), dans la position d'extrémité atteinte par ce dernier, à la suite de quoi, après retour du magasin (2) dans la position de départ, le chargement pas-à-pas du magasin (2) est à nouveau réalisé.

2. Procédé selon la revendication 1, **caractérisé en ce que** le déplacement du magasin (2) de la position de départ dans la position d'extrémité s'effectue de bas en haut dans la direction verticale.

3. Procédé selon la revendication 1, **caractérisé en ce que** le déplacement du magasin (2) depuis la position de départ dans la position finale s'effectue de haut en bas dans la direction verticale.

4. Dispositif pour la mise en oeuvre du procédé selon l'une des revendications 1 à 3 sur des composants électroniques situés sur des supports, le dispositif comportant un boîtier de mise en température (1) équipé d'organes de mise en température (11, 12) et possédant un magasin (2), qui est équipé d'organes de retenue (3) servant à recevoir les supports (4, 17, 21, 22, 24, 27, 34, 42) et contient un mécanisme de déplacement (7, 8, 9) pour déplacer le magasin (2), **caractérisé en ce que** le boîtier de mise en température (1) possède approximativement une hauteur égale au double de celle du magasin (2) et comporte, dans sa partie médiane, la fente d'entrée (15) et, dans une position opposée, la fente de sortie (19), que le magasin (2) est équipé d'un mécanisme de déplacement (7, 8, 9) pour son déplacement pas-à-pas aussi bien pour le chargement pas-à-pas sans interruption des différents organes de retenue ainsi que pour la sortie pas-à-pas, provoquée par le chargement, des organes de retenue situés respectivement dans une position flottante par rapport à la fente d'entrée et à la fente de sortie (15, 19) (position de réception), et que les organes de mise en température (11, 12) placent l'espace intérieur du boîtier (1) à une température réglable de telle sorte que, pendant le temps de séjour, les composants (18) prennent une température désirée.

5. Dispositif selon la revendication 4, **caractérisé en ce qu'**il est disposé en amont de la zone de fusion d'une installation de brasage (23) et que les organes de mise en température sont formés par des dispositifs de chauffage (11, 12).

6. Dispositif selon la revendication 4, **caractérisé en ce qu'**il est disposé en aval de la zone de fusion d'une installation de brasage (23) et que les organes de mise en température sont formés par des dispositifs de refroidissement (29).

7. Dispositif selon la revendication 4, **caractérisé par** une multiplicité de boîtiers de mise en température voisins (36, 39, 40, 41), dont les fentes d'entrée et de sortie (37, 38) sont reliées entre elles.
